# EUROPÄISCHE PATENTSCHRIFT

(11) **EP 0 704 068 B1**
(45) Veröffentlichungstag und Bekanntmachung des Hinweises auf die Patenterteilung: **13.09.2000**
(21) Anmeldenummer: 94916885.0
(22) Anmeldetag: 08.06.1994
(51) Int. Cl.: G02B 5/28, G02B 1/10, G02B 6/12

(54) **OPTISCHES BAUELEMENT**
OPTICAL COMPONENT
COMPOSANT OPTIQUE

(30) Priorität: 14.06.1993 DE 4319413
(43) Veröffentlichungstag der Anmeldung: 03.04.1996
(73) Patentinhaber: FORSCHUNGSZENTRUM JÜLICH GMBH, 52425 Jülich (DE)
(72) Erfinder: BERGER, Michael, Götz, D-53343 Wachtberg-Pech (DE); MÜNDER, Herbert, D-50127 Bergheim (DE); FROHNHOFF, Stephan, D-52064 Aachen (DE); THÖNISSEN, Markus, D-41334 Nettetal (DE); LÜTH, Hans, D-52076 Aachen (DE)
(86) Internationale Anmeldenummer: DE9400635
(87) Internationale Veröffentlichungsnummer: WO9429757

(56) Entgegenhaltungen:
- THIN SOLID FILMS, Bd.234, Nr.1-2, 25. Oktober 1993, LAUSANNE CH Seiten 356 - 362 ZALCZER ET AL 'IR Spectroscopic Ellipsometry: Instrumentation and Applications in Semiconductors'
- PATENT ABSTRACTS OF JAPAN vol. 10, no. 380 (P-528) 19. Dezember 1986 & JP,A,61 170 702 (KUNIO YOSHIDA) 1. August 1986

## Beschreibung

Die Erfindung bezieht sich auf ein optisches Bauelement, bestehend aus transparenten, dünnen Schichten unterschiedlicher Dicke und unterschiedlicher Brechungsindizes.

Derartige optische Bauelemente sind seit langem bekannt. So werden beispielsweise optische Bauelemente verwendet, deren Wirkung auf Interferenzeffekten in dünnen Schichten beruht. Hierbei handelt es sich beispielsweise uni Interferenzfilter und Spiegel. Die gewünschte Wirkung einer Schichtfolge, die i.A. aus Schichten mit zwei Materialien, die einen unterschiedlichen Brechungsindex besitzen, besteht, wird durch eine geeignete Wahl der Schichtfolge und der optischen Dicken der Einzelschichten bestimmt. Die sog. optische Dicke ist dabei die Dicke der Schicht multipliziert mit dem Brechungsindex. Diese optischen Schichtdicken sind dabei üblicherweise ganze Bruchteile derjenigen Wellenlänge, für die der Filter bzw. Spiegel ausgelegt ist. So besteht ein sog. Bragg-Reflektor aus einer periodischen Schichtfolge zweier Schichten mit möglichst verschiedenem Brechungsindex und einer optischen Schichtdicke von jeweils 1/4 derjenigen Wellenlänge, für die der Reflektor optimale Wirkung besitzen soll. Im Gegensatz dazu besitzt ein Fabry-Perot-Filter, der eine etwas modifizierte Schichtfolge aufweist, eine für eine bestimmte Wellenlänge festgelegte hohe Transmission, während für andere Wellenlängen der Filter lichtundurchlässig ist.

Optische Bauelemente aus Schichten mit graduell verändertem Brechungsindex sind als Wellenleiter oder als Antireflexbeschichtungen bekannt.

Es ist Aufgabe der Erfindung, anstelle der Schichten aus üblichen Materialien ein anderes Material einzusetzen.

Diese Aufgabe wird erfindungsgemäß dadurch gelöst, daß die Schichten aus porösem Silicium bestehen.

Die Herstellung eines Schichtsystems aus porösem Silicium kann auf unterschiedliche Arten realisiert werden:
a) Durch Variation der Stromstärke beim elektrochemischen Ätzprozeß zur Herstellung des porösen Siliciums können die Porosität und mithin die optischen Eigenschatten einer Einzelschicht in sehr einfacher Weise beeinflußt werden.
b) Die Verwendung einer Schichtfolge von unterschiedlich dotierten Silicium-Schichten als Ausgangsmaterial für den Ätzprozeß führt ebenfalls zu einer Änderung der Mikrostruktur und daher der optischen Eigenschaften. Bei den unterschiedlitt dotierten Schichten für das Ausgangsmaterial ist sowohl an eine Variation der Höhe als auch der Art der Dotierung gedacht. So sind u.a. folgende Dotierverläufe denkbar: pp⁺ pp⁺ npnp, pipi, graduelle Verläufe p ―> p⁺.
c) Bedingt durch das unterschiedliche Ätzverhalten von Si und SiGe kann eine Schichtfolge von Si/SiGe zur Herstellung eines porösen Schichtsystems verwendet werden.
d) Der Einfluß der Beleuchtung der Probe während des Ätzprozesses auf die Mikrostruktur kann zur Herstellung von Schichtsystemen genutzt werden. Es ist sowohl eine Variation der Stärke der Beleuchtung als auch eine Änderung des Spektrums des eingestrahlten Lichtes möglich.

Die unter a) bis d) genannten Verfahren lassen sich auch untereinander kombinieren, um so die optischen Eigenschaften des Schichtsystems optimal zu designen.

Das erfindungsgemäße Schichtsystem kann je nach dem angestrebten Anwendungsfall variiert werden und so die Emissions- bzw. Absorptionscharakteristik eines lichtemittierenden Bauelementes bzw. Photodetektors (Filter, Antireflexbeschichtung) beeinflußt werden. So besteht eine Version des optischen Bauelementes darin, daß die Schichten Dicken und Brechungsindizes in der Art eines Interferenzfilters aufweisen und als solches einsetzbar sind.

Die Filterwirkung wird durch eine periodische Abfolge von Schichten mit verschiedenen optischen Eigenschaften (dielektrischen Funktionen) erreicht. Je nach Schichtfolge sind verschiedene Arten von Filtern realisierbar (Bandpaß, Bandsperre, Fabry Perot-Filter), wobei die Filterwirkung auch durch die Hintereinanderschaltung von verschiedenartigen Filtern kombinierbar ist. Derartige Filter sind sowohl in der Optik als auch zur Beeinflussung der Emissionscharakteristik bei lichtemittierenden Bauelementen (z.B. farbiger Flachbildschirm ebenfalls aus porösem Silicium) und als Vorsatzfilter für Photodioden, z.B. bei Farbkameras, verwendbar.

Die besonderen Vorteile von porösem Silicium als Schichtmaterial liegen nicht nur in der leichten und billigen Herstellbarkeit von beliebig komplexen Schichtsystemen, sondern auch in der Möglichkeit, graduelle Übergänge im Brechungsindex zu erreichen.

Eine weitere Variante des erfindungsgemäßen optischen Bauelementes besteht daher auch darin, daß die Schichten einen kontinuierlich veränderten Brechungsindex besitzen und daher retlexmindernde oder reflexverstärkende Wirkung haben.

Die graduellen Übergänge im Brechungsindex sind dabei notwendig, um eine optimale Wellenführung in einem Lichtleiter zu erreichen, wie dies bei Glasfasern der Fall ist. Durch die Möglichkeit, auch in Schichtsysteman aus porösem Silicium graduelle Übergänge im Brechungsindex herzustellen, sind Wellenleiter auf einem Siliciumchip in sehr einfacher weise herstellbar. Bei einem wellenleiter sollte die Schichtfolge von porösem Silicium einen graduell zunehmenden und wieder abnehmenden Brechungsindex besitzen. Neben der Filterwirkung von Schichtsystemen kann somit durch eine graduelle Veränderung der optischen Eigenschaften eines Schichtsystems aus porösem Silicium eine reflexmindernde/reflexverstärkende Deckschicht hergestellt werden. Diese ist sowohl zur Verminderung der inneren Reflexionen bei der Auskopplung im Falle von Lichtemittierenden Strukturen wie Wellenleiter als auch zur Verringerung der Reflektivität bei Photodetektoren oder als Antireflexbeschichtung, z.B. für Solarzellen, einsetzbar.

In der Zeichnung sind Schichtsysteme gemäß der Erfindung schematisch dargestellt und werden im folgenden näher erläutert:

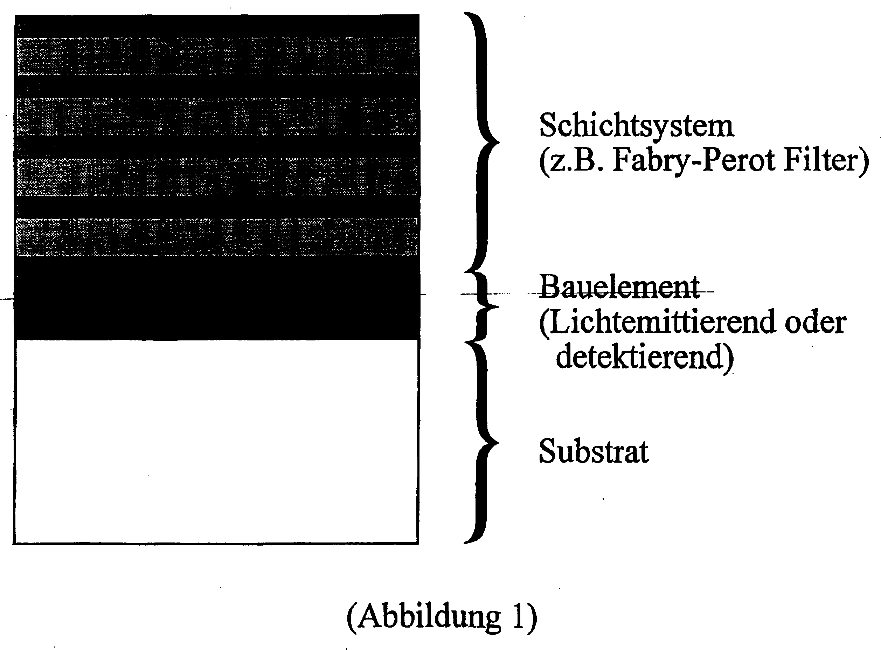

Es zeigen
- Abbildung 1: ein Schichtsystem als optischer Filter;

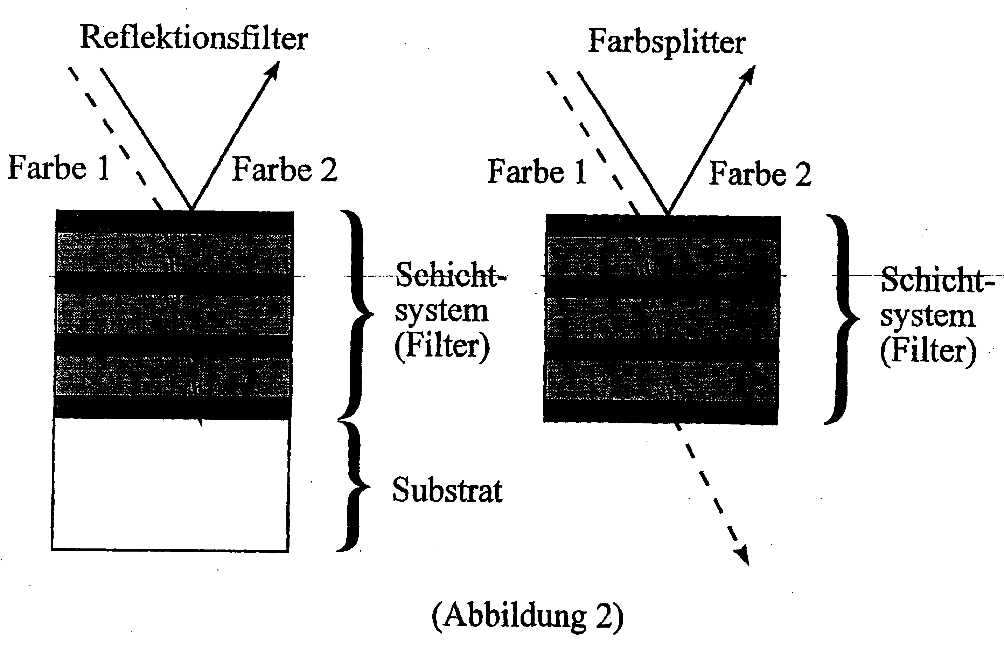

- Abbildung 2: unterschiedliche Anwendungen des Filterschichtsystems;

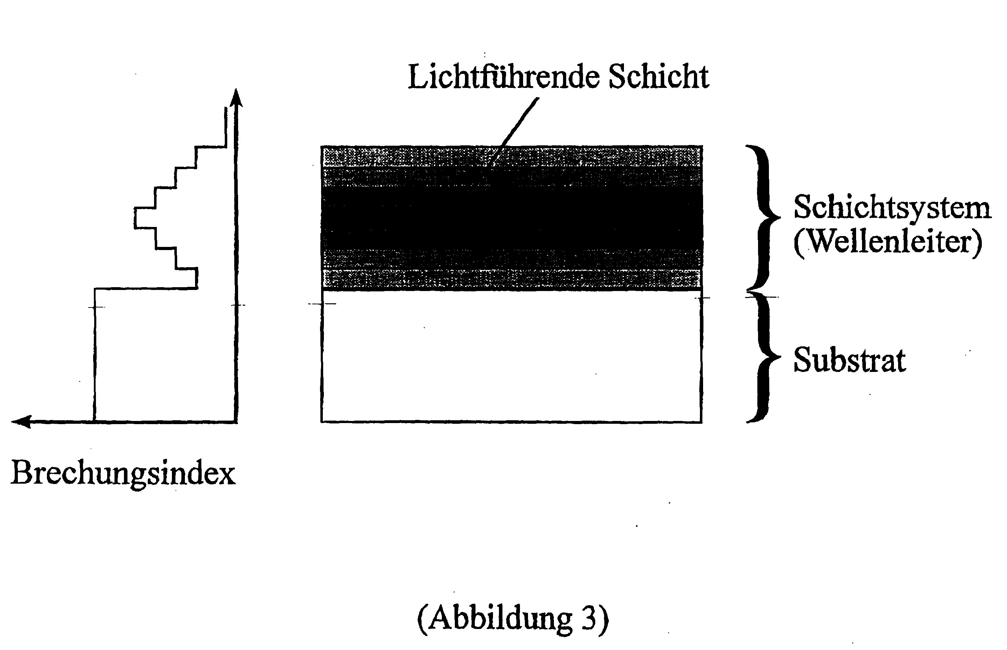

- Abbildung 3: Schichtsystem als Wellenleiter

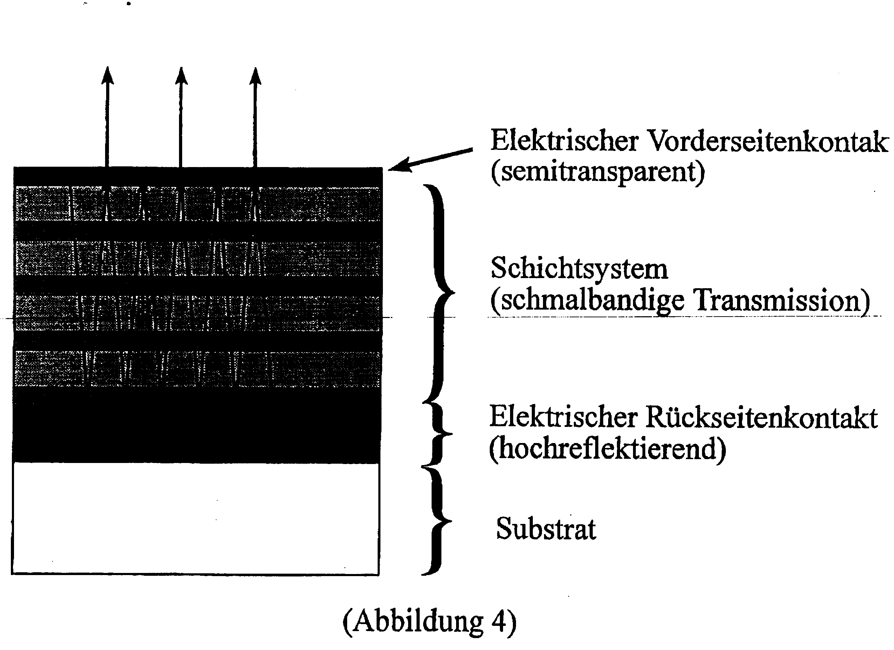

- Abbildung 4: Laserstruktur basierend auf einem Schichtsystem

### Abbildung 1:

Die Abbildung zeigt eine Struktur, die sich wie folgt zusammensetzt:

Direkt auf dem Substrat befindet sich der wesentliche Bestandteil des Bauelementes, welcher entweder Licht detektiert oder emittiert. Um eine schmalbandige Empfindlichkeit des Detektors bzw. eine schmalbandige Emission von Licht zu erreichen, wird über dieser Schicht ein Schichtsystem hergestellt, welches als Filter wirkt. Um eine Filterwirkung zu erreichen, wird ausgenutzt, daß Schichten verschiedener Porosität auch unterschiedlich große Brechungsindizes haben. Um ein Filter auf eine Wellenlänge l abzustimmen, wird abwechselnd eine hochporöse und eine niederporöse Schicht hergestellt, die alle eine optische Weglänge von 1/4 besitzen. Viele dieser Schichten bilden das SchichtsyStem. Dieses Schichtsystem kann z.B. ein Fabry-Perot Filter sein. Die gesamte Struktur wird in einem Äztvorgang aus einem Siliciumwafer elektrochemisch hergestellt.

### Abbildung 2:

Die Schichtsysteme aus porösen Silicium lassen sich sehr unterschiedlich anwenden. Zwei Anwendungen sind hier gezeigt:

Es kann ein Schichtsystem so hergestellt werden, daß es für die Wellenlänge der Farbe 1 durchlässig ist, während es für die Wellenlänge der Farbe 2 einen hochreflektierenden Spiegel darstellt. Wird diese Struktur auf einem Wafer hergestellt, so erhält man einen Reflektionsfilter für eine bestimmte Wellenlänge. Alle anderen Wellenlängen werden in dem Bauelement absorbiert. Diese Art der Anwendung ist auf der linken Seite der Abbildung dargestellt.

Wenn die nicht reflektierten Wellenlängen auch erwünscht sind, so wird das Filter freitragend hergestellt. Auf diese Weise wird ein Farbsplitter hergestellt, der eine bestimmte Wellenlänge reflektiert und die anderen durchläßt. Diese Struktur ist auf der rechten Seite der Zeichnung abgebildet.

### Abbildung 3:

Wenn ein Lichtleiter auf einem Chip erwünscht ist, so kann dieser auch direkt aus dem Siliciumwafer des Chips hergestellt werden. Auf dem Wafer wird dazu ein Schichtsystem hergestellt, welches einen Verlauf im Brechungsindex aufweist, wie er auf der linken Seite der Zeichnung abgebildet ist. Die lichtführende Schicht liegt in der Mitte des Schichtsystems und besitzt den größten Brechungsindex. Die Einkopplung des Lichtes erfolgt vom seitlichen Rand des Schichtsystems.

### Abbildung 4:

Wird auf eine poröse Schicht ein semitransparenter Vorderseitenkontakt aufgebracht und unter der porösen Schicht ein hochreflektierender elektrischer Rückseitenkontakt, so kann ein Resonator für eine bestimmte Wellenlänge hergestellt werden. Um einen Laser aus Silicium zu bauen, wird ein Mechanismus benötigt, der eine induzierte Emission im falschen Wellenlängenbereich unterbindet. Dazu wird die Schicht in dem Resonator als Übergitter hergestellt, welches eine schmalbandige Transmission für die gewünschte Wellenlänge hat. Auf diese Weise sollte es möglich sein, trotz der breitbandigen Lumineszenz des porösen Siliciums einen Laser aus diesem Material zu bauen.

## Patentansprüche

1. Optisches Bauelement, bestehend aus transparenten, dünnen Schichten unterschiedlicher Dicke und unterschiedlicher Brechungsindizes,
**dadurch gekennzeichnet,**
daß die Schichten aus porösem Silicium bestehen.

2. Optisches Bauelement nach Anspruch 1,
**dadurch gekennzeichnet,**
daß die Schichten Dicken und Brechungsindizes in der Art eines Interferenzfilters oder Interferenzspiegels aufweisen und als solche einsetzbar sind.

3. Optisches Bauelement nach Anspruch 1,
**dadurch gekennzeichnet**,
daß die Schichten einen kontinuierlich veränderten Brechungsindex besitzen.

4. Optisches Bauelement nach Anspruch 3,
**dadurch gekennzeichnet,**
daß die Schichtfolge einen graduell zunehmenden und wieder abnehmenden Brechungsindex besitzt.

## Claims

1. Optical component comprising transparent thin layers of different thickness and different refractive indices, **characterised in that** the layers are made of porous silicon.

2. Optical component according to Claim 1 **, characterised in that** the layers comprise thicknesses and refractory indices of the type of an interference filter or interference mirror and are applicable as such.

3. Optical component according to Claim 1, **characterised in that** the layers have a continuously changeable refractory index.

4. Optical component according to Claim 3, **characterised in that** the layer sequence has a gradually increasing and again decreasing refractory index.

## Revendications

1. Composant optique, constitué de minces couches transparentes d'épaisseurs différentes et d'indices de réfraction différents, caractérisé en ce que les couches sont en silicium poreux.

2. Composant optique suivant la revendication 1, caractérisé en ce que les couches ont des épaisseurs et un indice de réfraction du genre d'un filtre à interférence ou d'un miroir à interférence et peuvent être utilisées comme telles.

3. Composant optique suivant la revendication 1, caractérisé on ce que les couches ont un indice de réfraction qui varie de manière continue.

4. Composant optique suivant la revendication 3, caractérisé en ce que la succession de couches a un indice de réfraction qui augmente graduellement et diminue à nouveau.
